# EUROPEAN PATENT SPECIFICATION

(11) **EP 0 357 248 B1**
(45) Date of publication and mention of the grant of the patent: **01.03.1995**
(21) Application number: 89307963.2
(22) Date of filing: 04.08.1989
(51) Int. Cl.: H01L 29/08, H01L 29/66

(54) **Semiconductor device of the quantum interference type**
Quantuminterferenzhalbleitereinrichtung
Dispositif semi-conducteur du type à interférence quantique

(30) Priority: 04.08.1988 JP 195666/88; 14.11.1988 JP 287058/88
(43) Date of publication of application: 07.03.1990
(73) Proprietor: FUJITSU LIMITED, Kawasaki-shi, Kanagawa 211 (JP)
(72) Inventor: Arimoto, Hiroshi, Yokohama-shi Kanagawa 227 (JP); Muto, Shunichi, Atsugi-shi Kanagawa 243-01 (JP); Sasa, Shigehiko, isehara-shi Kanagawa 259-11 (JP); Okada, Makoto, Isehara-shi Kanagawa 259-11 (JP); Yokoyama, Naoki, Atsugi-shi Kanagawa 243 (JP)
(74) Representative: Fane, Christopher Robin King

(56) References cited:
- INTERNATIONAL ELECTRON DEVICES MEETING, 1986, pages 76-79, IEEE, New York, US;S. BANDYOPADHYAY et al.: "A novel quantum interference transistor (QUIT) withextremely low power-delay product and very high transconductance"
- IEEE ELECTRON DEVICE LETTERS, vol. EDL-6, no. 12, December 1985, pages 636-638,IEEE, New York, US; A.R. BONNEFOI et al.: "Resonant tunneling transistors withcontrollable negative differential resistances"
- APPLIED PHYSICS LETTERS, vol. 47, no. 12, December 1985, pages 1347-1349,
- American Institute of Physics, Woodbury, New York, US; S. LURYI et al.:"Resonant tunneling of two-dimensional electrons through a quantum wire: Anegative transconductance device"

## Description

The present invention relates to a semiconductor device of the quantum interference type.

Recently, owing to rapid developments in electronic apparatus such as electronic computers, a need for a high-speed semiconductor device has arisen. In view of this a very high speed quantum interference type semiconductor device having a heterostructure has been proposed. In such a device, the quantum interference effect of wave functions of an electron at the heterojunction between semiconductor materials with different band gaps, for example a heterojunction between an undoped GaAs layer and an undoped AlGaAs layer wherein a two-dimensional electron gas layer is produced, is utilized.

It is desirable to provide a quantum interference type semiconductor device having good quantum interference characteristics.

The applicants have noted that in quantum interference type semiconductor devices having a bifurcated branch conductive channel with a heterojunction in the semiconductor with a band discontinuity, in which the conductance of the channel is controlled by controlling a phase difference of the wave functions of an electron travelling in the channel, the following conditions are necessary to achieve good quantum interference:-
(1) The energy of the electrons injected into the channel should be equal; and
(2) Inelastic scattering of the wave functions of an electron travelling in the channel should be prevented.

In order to realise condition (2), the distance between a source and a drain in the device must be less than or equal to 1 »m.

According to the present invention there is provided a semiconductor device of the quantum interference type having channel means for passing carriers from a first region of the device into which carriers are injected to a second region of the device from which carriers are drained, at least part of the said channel means comprising two conductive paths extending in parallel between the first and second regions, and there being field control means arranged for subjecting the said conductive paths to a selectively variable electric or magnetic field so as to control the passage of carriers through the said channel means by means of the Aharonov-Bohm effect; characterised by a resonance-tunnelling barrier arranged for restricting the energy levels of carriers entering the said conductive paths to a predetermined narrow band of energy levels.

The resonance tunnelling barrier structure functions as a bandpass filter having a high quality factor Q for passing electrons having a certain narrow energy level range into the conductive paths, so that the travelling speed of the electrons in the conductive paths due to the energy level becomes uniform and the dispersion of the phase difference becomes slight, thereby realising good quantum interference.

In an embodiment of the present invention, the distance between the source electrode and the drain electrode in the device can be made less than or equal to 1 »m by forming the source electrode thereof, the resonance tunnelling barrier structure, the channel, and the drain electrode in that order on the semiconductor substrate, in such a way that a drain current flows perpendicular to the semiconductor substrate, so that the inelastic scattering of wave functions of an electron travelling in the channel means can be prevented.

Reference will now be made, by way of example, to the accompanying drawings, wherein:
Fig. 1 shows schematically a view of a known quantum interference effect type semiconductor device for use in explaining a quantum interference effect;
Fig. 2 is a graph illustrating the variation of the conductance in dependence upon phase difference in the device of Fig. 1;
Fig. 3 shows respective wave functions appearing in the device of Fig. 1;
Fig. 4 shows a cross-sectional view of a previously-proposed quantum interference transistor;
Fig. 5 shows a cross-sectional view of a first quantum interference type semiconductor device embodying the present invention;
Fig. 6 shows a cross-sectional view of a second quantum interference type semiconductor device embodying the present invention;
Fig. 7A and Fig. 7B are energy band diagrams;
Fig. 8 is a diagram for use in explaining embodiments of the present invention;
Fig. 9 is another diagram for use in explaining embodiments of the present invention; and
Figs. 10A and 10B show respective cross-sectional views for use in explaining the process of manufacturing a third quantum interference type semiconductor device embodying the present invention, which is illustrated in cross-section in Fig. 10C.

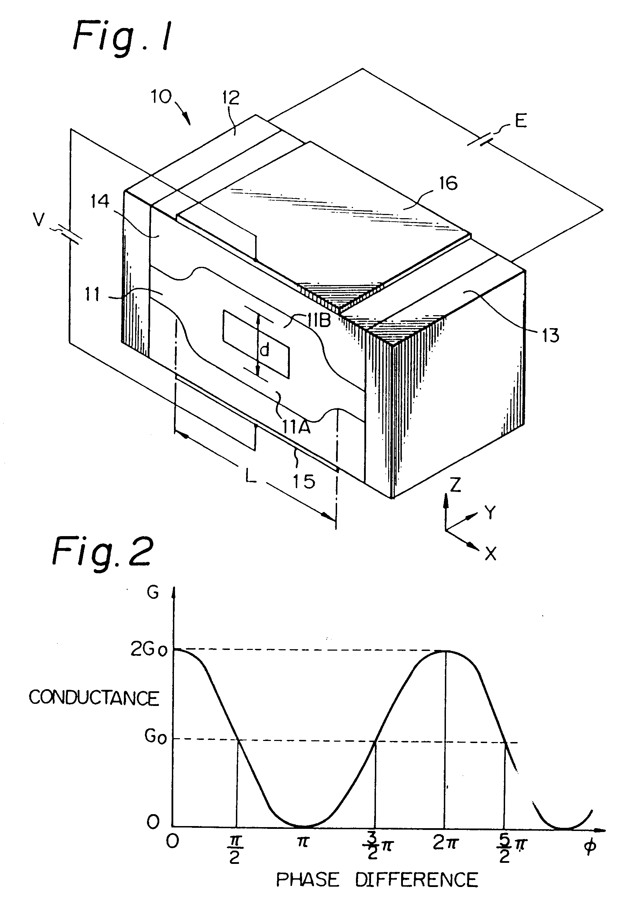

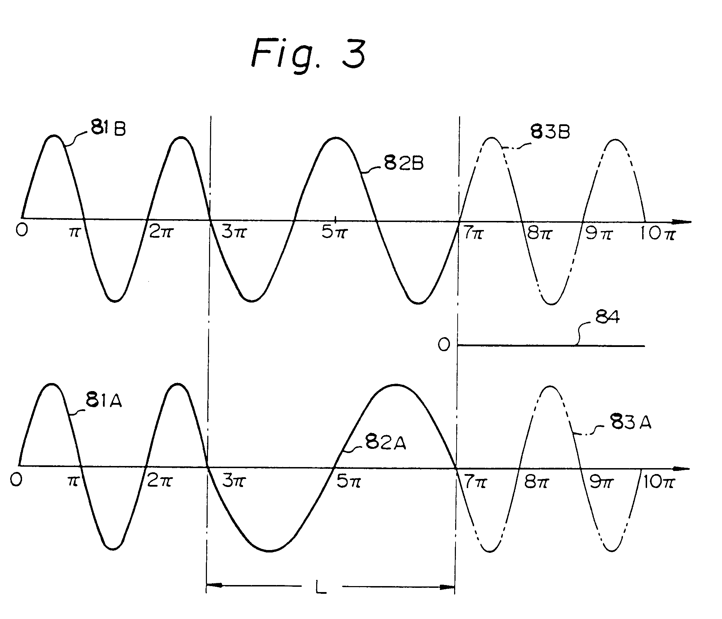

Before describing embodiments of the present invention, an explanation will be given of the quantum interference effect with reference to a quantum interference effect element model such as a semiconductor functional element known as a semiconductor interferometer shown in Fig. 1 and characteristic curves shown in Figs. 2 and 3.

The quantum interference effect element shown in Fig. 1 is of similar construction to the semiconductor interferometer shown in U.S. Pat. No.4,550,330, issued Oct. 29, 1985, to Alan B. Fowler et al., which purports to disclose that "An interferometer is constructed by providing a bifurcated branch conductive path coplanar with a heterojunction in a semiconductor with a band discontinuity that produces a potential well so that electron wave conduction at the heterojunction can be locally influenced with an electric field applied to one branch of the bifurcated path." Further, developments and research on the quantum interference effect are now proceeding, for example, see "S. Datta et al. Phys. Rev. Lett.55 1985 p.2344","S. Datta et al. Appl. Phys. Lett.48 1986 p.487", and "S. Bandyopadhyay et al IEDM-86 Tech. Dig. p. 76".

In Fig. 1, reference numeral 10 indicates a quantum interference effect element, 11 indicates a channel, made of GaAs, through which electrons travel, 11A and 11B indicate respective conductive paths or branches in the channel 11, 12 indicates an input contact, 13 indicates an output contact, 14 indicates a nonconductive layer made of AlGaAs which forms a "barrier" (as compared with a "well"), 15 and 16 indicate electrodes, L indicates the length of each of the conductive paths 11A, 11B, and E and V indicate respective power sources.

In a quantum interference effect element as constructed above, when a signal is provided at the input contact 12, the wave functions of an electron are divided into two groups at the point of bifurcation of the channel 11. One group of wave functions of the electron travels in the branch path 11A and the other group of wave functions of the electron travels in the branch path 11B, both groups of wave functions of the electron then being added together after travelling through the path 11A and 11B and arriving at the output contact 13. In this process, when an electric field is applied to the paths 11A and 11B by connecting the electrodes 15 and 16 to the power source V, or when a magnetic field is applied perpendicular to the paths 11A and 11B, the wave functions of the electrons in the paths 11A and 11B are influenced by the local electric field or magnetic field and a phase shift occurs in dependence upon the potential of the field, thereby causing wave interference when the two groups of electron wave functions are added together. In other words, when the electric or magnetic field is applied the amount of phase shift of the electron wave functions in the path 11A differs from that of the electron wave function in the path 11B, thereby causing a phase difference between the electron wave function in the paths 11A and 11B. This effect is known as the Aharonov-Bohm effect.

The transmission factor due to the wave interference is expressed as shown in Equation 1, in terms of the conductance G:-${\text{G = G}}_{\text{o}} \text{(1 + [cos φ])}$
where 2Gₒ is the conductance when there is no wave interference (cos φ = 1), parentheses ([ ]) are the ensemble average of electrons, and φ is the phase difference value in the wave function of electrons owing to the application of an electric field or a magnetic field.

The phase difference value φ when the electric field is applied is expressed, as shown in Equation 2, as a function (electrostatic Aharonov-Bohm effect) of an electric field ε_{z} applied to the branch paths 11A and 11B in the direction of a Z-axis (Fig. 1)):-${\text{φ = e * ε}}_{\text{z}} {\text{* L * d / (ℏ * V}}_{\text{x}} \text{)}$
where e is an elementary quantity of an electric charge, L is the length of the branch paths 11A and 11B, d is the distance between the center of the branch paths 11A and 11B, ℏ is Planck's constant /2π, and Vx is a travelling speed of the electrons.

Thus it can be seen that the phase difference value can be controlled by changing the strength of the electric field applied to the branch paths 11A and 11B, thereby controlling the conductance G which is a function of the phase difference φ . Fig. 2 is a chart illustrating the characteristics of the variation of the conductance G (vertical axis) with the phase difference φ (horizontal axis) in each branch path 11A and 11B.

Fig. 3 shows waveforms for explaining the operation of the signal applied at the input contact 12 of the semiconductor functional element 10 shown in Fig. 1. In Fig. 3, reference numerals 81A and 81B indicate waveforms of the signal travelling in the channel 11 before reaching the branch paths 11A and 11B, 82A indicates a waveform of the signal travelling in the branch path 11A, 82B indicates a waveform of the signal travelling in the branch path 11B, 83A and 83B indicate "phantom" waveforms of the respective signals in the channel 11 after it has travelled through the branch paths 11A and 11B as if the two signals existed without being added together, and 84 indicates a real output signal from the output contact 13 after summing the two waveforms 83A and 83B. In this embodiment, the phase of the signal travelling in the branch path 11A is shifted by 2π, and that in the branch path 11B is shifted by π, by adjusting the strength of the electric field applied to the element 10 so as to produce a zero output signal 84.

As mentioned above, the quantum interference effect in the known semiconductor functional element shown in Fig. 1 is dependent not only on the parameter ε_{z} of an electric field applied to the branch paths 11A and 11B in the direction of the Z-axis , but also on the parameter Vx, i.e. the travelling speed, of the electrons. Accordingly, if the electrons have a range of travelling speeds, that is if the electrons have a range of energy levels, by Equation 2 there will also be a range of phase difference values φ which will cause the variation degree ΔG of the conductance to become small. If the value ΔG/G is not large enough the usefulness of the device becomes unduly limited. Accordingly, it is desirable that the respective energy levels of the electrons travelling in the channel should be substantially equal.

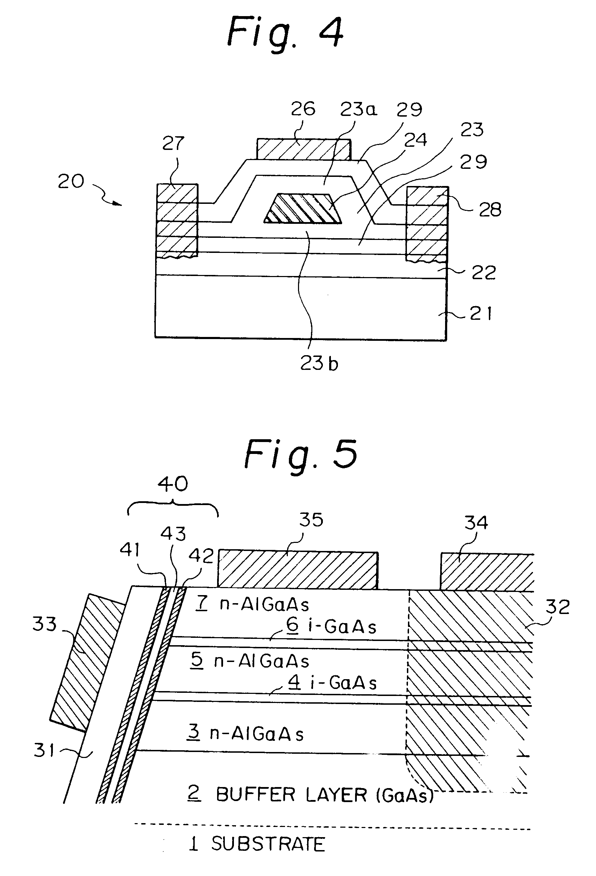

Figure 4 shows a cross-sectional view of a previously-proposed quantum interference transistor 20, in which reference numeral 21 indicates a semiconductor substrate, 22 indicates a buffer layer, 23 indicates a channel, 24 indicates a channel separator, 26 indicates a gate electrode, 27 indicates a source electrode, 28 indicates a drain electrode, and 29 indicates respective high resistance layers. The channel separator 24 and the high resistance layers 29 are, for example, made of n-type AlGaAs. The channel 23 is, for example, made of GaAs, and forms a heterojunction structure with the high resistance layer 29 wherein a two-dimensional electron gas layer is produced at the GaAs side of the interface with the n-type AlGaAs layer. The channel 23 is bifurcated, i.e. divided into two paths 23a and 23b, by the separator 24 and the gate electrode 26 is arranged adjacent to the path 23a so as to allow the conductance of the paths 23a and 23b to be changed by applying an electric field thereto.

Contact regions of the source electrode 27 and the drain electrode 28 form an n⁺ region having a relatively large dimension, and a current flowing between the source electrode 27 and the drain electrode 28 is principally parallel to the semiconductor substrate 21. As a result, it can be very difficult to form the path 23a, the channel separator 24, and the path 23b in such a way that the respective thicknesses of those layers is less than or equal to 0.1»m, and to form the source electrode 27 and the drain electrode 28 in such a way that the distance between those electrodes is less than or equal to 1»m.

Contrary to this, in the quantum interference type semiconductor device embodying the present invention which is described hereinafter, the energy levels of the electrons travelling along each path are equal. Further, in a quantum interference type semiconductor device embodying the present invention in which the channel is formed vertically on the semiconductor substrate, the distance between the source electrode 27 and the drain electrode 28 is less than or equal to 1 »m.

The construction of a first quantum interference type semiconductor device embodying the present invention will now be described with reference to Fig. 5, in which reference numeral 1 denotes a monocrystalline substrate, 2 denotes a buffer layer of GaAs, 3 denotes a first n-AlGaAs layer, 4 denotes a first i-GaAs layer, 5 denotes a second n-AlGaAs layer, 6 denotes a second i-GaAs layer, 7 denotes a third n-AlGaAs layer, 31 denotes a source contact layer, 32 denotes an alloy region for ohmic contact called a drain contact region formed by the diffusion of impurities, 33 denotes a source electrode, 34 denotes a drain electrode, 35 denotes a gate electrode constituting field control means, and 40 denotes a resonance tunnelling barrier comprising a first barrier layer 41, a second barrier layer 42, and a well layer 43.

The quantum interference type semiconductor device of Fig. 5 is formed by using an epitaxial crystal constructed by the following process:-
① First, the buffer layer 2 of GaAs is grown on the mono-crystalline substrate 1 made of GaAs, then n-AlGaAs layers 3,5 and 7 and undoped i-GaAs layers 4 and 6 are epitaxially grown in turn on the substrate 1 using a MOCVD method or a molecular beam epitaxy (MBE) method. Note that the i-GaAs layers 4 and 6 constitute current paths which correspond respectively to the branch paths 11A and 11B of Fig. 1, and these layers 4 and 6 are conductive by receiving electrons from the n-AlGaAs layers located on both sides thereof in this embodiment, although the branch paths 11A and 11B are themselves conductive owing to the heterostructure of the bands. Also, it should be clear that the respective thicknesses of the i-GaAs layers 4 and 6 are merely a matter of design.
② Second, etching of the side of the epitaxial crystal, formed as described above, is carried out and an inclined plane is made whereon a resonance tunneling structure will be formed. The reason for forming the inclined plane is that the object of the processing is an epitaxial crystal having a wafer condition. If a processing method which can grow a certain crystal on the perpendicular plane is adopted, the shape of the side of the epitaxial crystal should not be inclined but should be perpendicular. For the etching method, a Cl₂ gas etching method, in which ultraviolet light having a wavelength of approximately 250 nm is irradiated in the etching process, can be used. This etching method is suitable for forming an inclined plane since it shows an anisotropy due to a plane direction, and this method does not cause any mechanical damage to an element forming region.
③ Third, the resonance tunneling barrier 40, having the first tunneling barrier layer 41, the well layer 43, and the second tunneling barrier layer 42, is formed on the inclined plane. In the resonance tunneling barrier 40 the well layer 43, which is several nanometres thick and is made of GaAs, is sandwiched between two barrier materials 41 and 42 having a similar thickness and made of a material having a wider band gap than GaAs, such as AlGaAs. The resonance tunneling barrier structure, which is a super-lattice structure, can be formed by atomic layer epitaxy, which provides a material having a repeated self-limiting effect with a predetermined time unit. The number of atomic layers included in each layer is determined by the element design.
④ Fourth, the source contact layer 31 is formed by growing a layer of n⁺ -GaAs epitaxially on the resonance tunneling barrier 40, and then a source electrode 33 made of Cr/Au is formed on the source contact layer 31 (non-alloy contact layer using n ⁺-InGaAs cap layer) by evaporation or the like. The drain contact region 32 is formed as the alloy region for an ohmic contact by the diffusion of impurities, and the drain electrode 34, which is made of AuGe/Au material, is arranged next to the drain contact region 32. Further, the gate electrode 35, for use in applying a control voltage to the electron paths 4 and 6, is formed on the surface of the third n-AlGaAs layer 7. This gate electrode 35 forms a Schottky barrier against the third n-AlGaAs layer 7 and is made of Al, for example. The phase difference between the paths 4 and 6 can be controlled in dependence upon the voltage applied to the gate electrode 35.

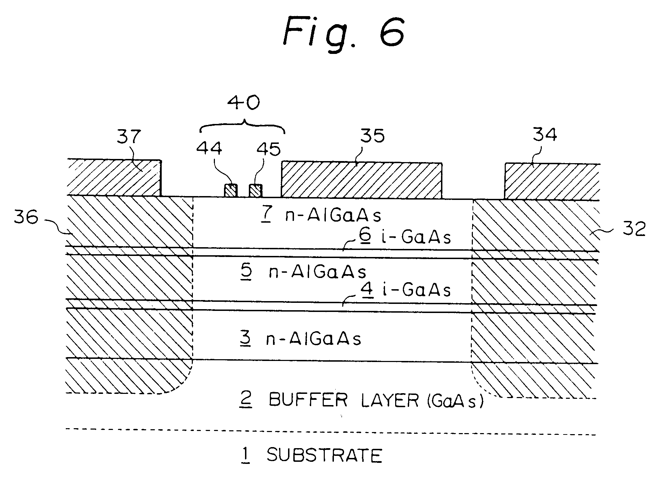

Additionally, the resonance tunneling barrier 40 can be formed by another method such as applying a partial voltage to the paths 4 and 6 using resonance tunneling electrodes. This method will be described with reference to Fig. 6, which illustrates a second device embodying the present invention. In Fig. 6, much of the structure is the same as the structure shown in Fig. 5, so that for the same structure, the same reference numerals are used, and the explanation thereof will be omitted. In Fig. 6, reference numeral 36 denotes a source contact region formed as the alloy region for an ohmic contact by the diffusion of impurities, 37 denotes a source electrode made of AuGe/Au material, and 40 denotes a resonance tunneling barrier comprising two lines of resonance tunneling electrodes 44 and 45 of Schottky-barrier-type arranged on the surface of the third n-AlGaAs layer 7 between the gate electrode 35 and the source contact region 36 in a direction perpendicular to that in which the paths 4 and 6 extend.

In this embodiment, when a bias voltage is applied to the resonance tunneling electrodes 44 and 45, the potential under the resonance tunneling electrodes 44 and 45 is changed and an effective resonance tunneling barrier will be formed, so that the travelling speed of the electrons downstream of the resonance tunneling electrodes 44 and 45 becomes uniform.

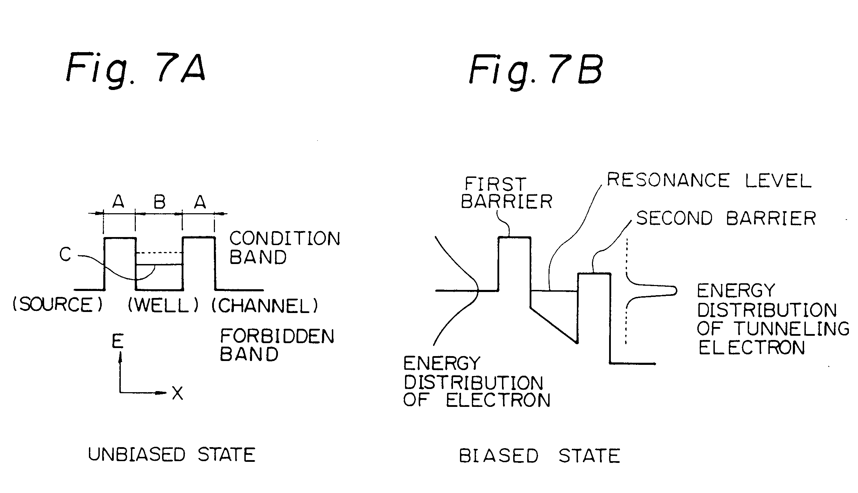

Figures 7A and 7B are energy band diagrams for explaining the function of the resonance tunneling barrier in an embodiment of the present invention. Fig. 7A shows an unbiased state of the energy band of the resonance tunneling barrier, i.e. where there is no bias voltage in the X direction. In Fig. 7A, reference A denotes a semiconductor region having a comparatively wide forbidden band, B denotes a semiconductor region having a comparatively narrow forbidden band, and C denotes a resonance level. The semiconductor region near the source electrode is called a first barrier and the semiconductor region near the drain electrode is called a second barrier.

When the semiconductor region B is sandwiched between two semiconductor regions A in the unbiased state, a standing wave of the electron occurring in the electron well (semiconductor region B) lies between the first and second barriers (semiconductor region A) from the view point of the conduction band. When a bias voltage is applied in the X direction, in other words when an electric field in the X direction is applied, the energy band alters as shown in Fig. 7B, and when the energy level of the standing wave and the lower level of the conduction band become equal, the tunneling probability of electrons having the same energy level as the lower level of the conduction band approaches "1", while the tunneling probability of electrons having other energy levels approaches "0".

That is, the resonance tunneling barrier functions as a band-pass filter having a very high quality factor Q which permits electrons being resonant with the quantum well to pass. Accordingly, in a biased state, among the group of electrons having a widespread range of energy levels owing to heat, as shown on the left of Fig. 7B, only the group of electrons having an energy level equal to the resonance level C can pass through the first and the second barriers, as shown on the right of Fig.7B. Thus, in effect, only electrons in a narrow energy band are injected into the channel.

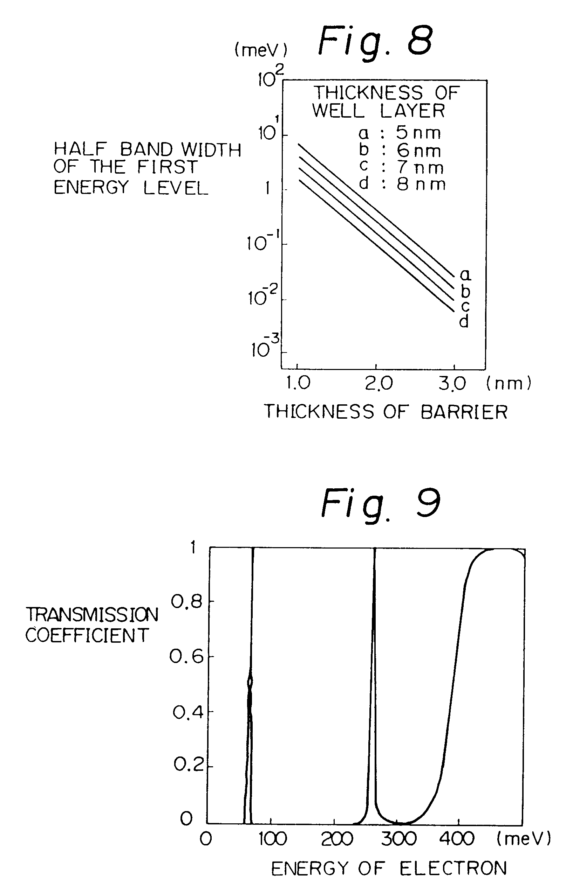

Figure 8 is a diagram showing the relationship between the thickness of the barrier forming the quantum well and a half band width ΔE of the energy level of the lowest order of the standing wave, as reported by M. Tsuchiya et al. in Applied Electronic Materials Meeting Research Report, No. 410, p.25 . In Fig. 8, references a, b, c, and d denote parameters showing the thickness of the well layer. The value Δ E = 30 ∼ 60 »eV realized by providing a resonance tunneling barrier in a quantum interference type semiconductor device is small enough in comparison with the heat energy at room temperature, and also smaller in one figure as compared with the heat energy of 0.36 meV at 4.2 K, that the deviation of the injected energy due to the heat at the Fermi plane can be ignored.

Figure 9 is a diagram showing a relation between the energy of the electrons and a transmission coefficient. Fig. 9 shows that the standing waves existing in the quantum well are not only of a first degree but also of a high order (the peak level at 65 meV is due to the first degree of the resonance level and at 260 meV is due to the second degree thereof). The ratio of the respective travelling speeds V₁ and V₂ of electron injected with those of the first and second degrees of the energy level is expressed as shown in the following equation 3:-${\text{V₁/V₂= (269meV/65meV)}}^{\text{1/2}} \text{= 2}$
Thus, by equation 2, the ratio of phase differences in each case, with the same control voltage ε_{z}, is 1/2 and the period of the conductance G doubles. In this way, by providing a resonance tunneling barrier at the injection part of the semiconductor device, it is possible to change the characteristics of the element by selecting the working conditions of the device without additionally having to change the dimensions of the element.

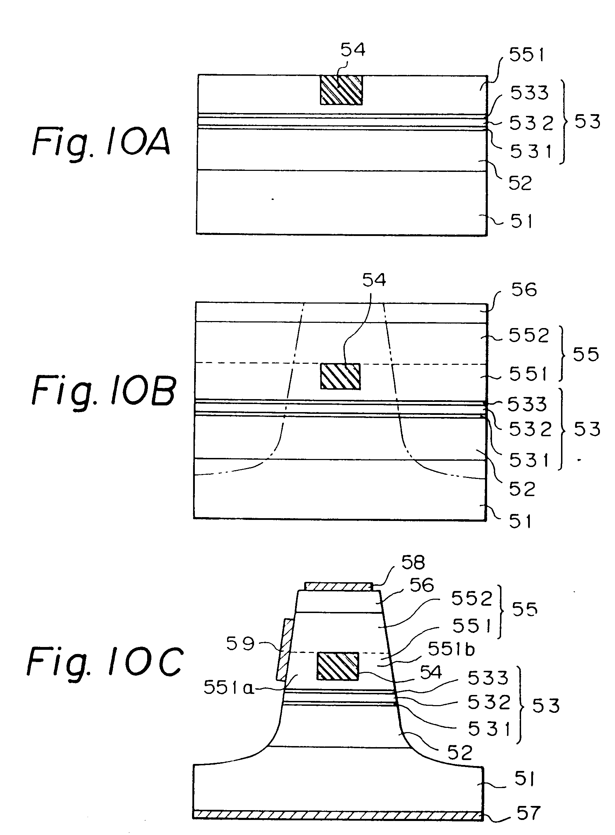

Figure 10C shows a cross-sectional view of a third quantum interference type semiconductor device embodying the present invention, in which reference numeral 51 denotes a semiconductor substrate, 52 denotes a buffer layer called a source contact layer, 53 denotes a resonance tunneling barrier comprising a first barrier layer 531, a quantum well layer 532, and a second barrier layer 533, 54 denotes a channel separator, 55 denotes a channel comprising a first channel layer 551 and a second channel layer 552, 56 denotes a drain contact layer, 57 denotes a source electrode, 58 denotes a drain electrode, and 59 denotes a gate electrode. Further, the first channel layer 551 is separated into two paths 551a and 551b by the channel separator 54.

Reference will now be made to Figures 10A and 10B to explain how the quantum interference type semiconductor device of Fig. 10C may be manufactured.

First, the buffer layer 52, the resonance tunneling barrier 53, having the first barrier layer 531, the quantum well layer 532 and the second barrier layer 533, and the first channel layer 551 are formed, in that order, on the semiconductor substrate 51 by means of the molecular beam epitaxy (MBE) method. One example of the composition and the thickness of each layer is as follows:-

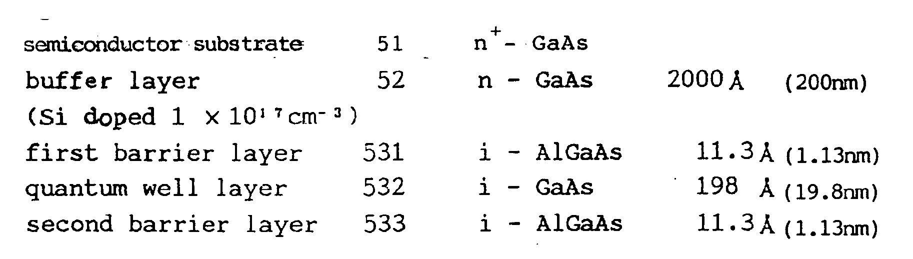

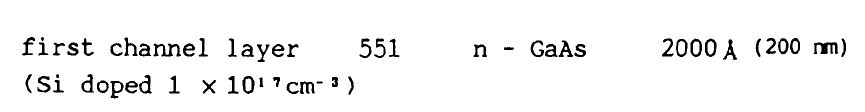

Second, the channel separator 54 having a width of 0.2 »m, a depth of 0.15 »m from the surface, and a dose amount of 1 ∼ 5 × 10¹⁴cm⁻² is formed in the first channel layer 551 by means of maskless ion injection of boron ion (B⁺) using a focusing ion beam having an accelerating voltage of 40keV and a diameter of 0.1 »m. This channel separator 54 has a high-resistance and prevents electrons from invading therein.

Third, the second channel layer 552 and the drain contact layer 56 are formed, in that order, on the first channel layer 551 by means of the molecular beam epitaxy (MBE) method. One example of the composition and the thickness of each layer is as follows:-

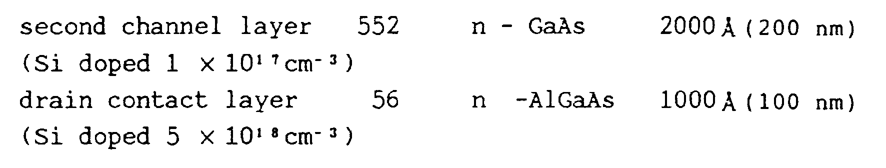

As mentioned above, the channel 55 comprises the first channel layer 551 and the second channel layer 552 having the same composition, the first channel layer 551 being separated into two paths 551a and 551b by the channel separator 54. The electrons having travelled through the channel 55 flow into the drain contact layer 56.

Fourth, etching into the form of a mesa, as shown by the phantom line in Fig. 10B, is carried out, the top surface of the structure being substantially of square plan and having sides which are each of 0.4 »m in length. Then the gate electrode 59 is formed on one side of the channel 55, a source electrode 57 is formed on the lower surface of the semiconductor substrate 51, and the drain electrode 58 is formed on the top surface of the drain contact layer 56.

In this way, in the quantum interference type semiconductor device of Fig. 10C, the channel 55 for the flow of drain current is formed in a direction perpendicular to the semiconductor substrate 51 so that it is possible to shorten the distance between the source electrode 57 and the drain electrode 58. For example, if the device is formed by using the molecular beam epitaxy method, the distance between the source electrode 57 and the drain electrode 58 can be less than or equal to 0.1»m. When the distance between the source electrode 57 and the drain electrode 58 is comparatively short, the chance of the inelastic scattering of wave functions of an electron travelling in the channel is decreased,thereby increasing the interference effect.

It should be noted that more than one gate electrode can be arranged beside the channel, that more than one channel can be made in the semiconductor device, and that a common electrode facing the gate electrode can be arranged on the other side of the channel in the above-described embodiments, although these features are not shown.

## Claims

1. A semiconductor device of the quantum interference type having channel means (4,6;55) for passing carriers from a first region (31;36;52) of the device into which carriers are injected to a second region (32;56) of the device from which carriers are drained, at least part of the said channel means (4,6;55) comprising two conductive paths (4,6;551a,551b) extending in parallel between the first and second regions (31;36;52/32;56), and there being field control means (35;59) arranged for subjecting the said conductive paths to a selectively variable electric or magnetic field so as to control the passage of carriers through the said channel means (4,6;55) by means of the Aharonov-Bohm effect; characterised by a resonance-tunnelling barrier (40;53) arranged for restricting the energy levels of carriers entering the said conductive paths (4,6;551a,551b) to a predetermined narrow band of energy levels.

2. A semiconductor device as claimed in claim 1, wherein said resonance-tunnelling barrier is disposed between said first region (31;52) and one end of said channel means (4,6;55) and comprises a first barrier layer (41;531), a quantum well layer (43;532), and a second barrier layer (42;533).

3. A semiconductor device as claimed in claim 1, wherein said resonance-tunnelling barrier comprises two lines of resonance-tunnelling electrodes (44,45) for applying a partial voltage to said channel means (4,6), which electrodes (44,45) are disposed alongside the said channel means (4,6) at one end of said conductive paths (4,6) which is adjacent to said first region (36) of the device.

4. A semiconductor device as claimed in claim 2 or 3, wherein said channel means (4,6) are formed as parallel potential wells in a semiconductor heterostructure with a band discontinuity on a monocrystalline substrate (1), said resonant-tunnelling barrier (40) and said first region (31;36) being arranged in that order at a source side of said heterostructure, and said second region (32) being arranged at the drain side of said heterostructure.

5. A semiconductor device as claimed in claim 2 or 3, wherein said first region (52), said resonnant-tunnelling barrier (53), said channel means (55), and said second region (56) are laminated in that order on a semiconductor substrate (51).

6. A semiconductor device as claimed in claim 4 or 5, wherein said field control means (35;59) comprise a gate electrode disposed on one side of said channel means (4,6;55) and a common electrode disposed on the opposite side of said channel means (4,6,55) so as to face said gate electrode (35;59).

7. A semiconductor device as claimed in claim 6, wherein an additional gate electrode (35) is provided on one side of said channel means (4,6), the gate electrodes (35) being ON/OFF controllable independently of one another.

8. A semiconductor device as claimed in claim 7, wherein additional channel means (4,6) are formed in said semiconductor heterostructure.

## Patentansprüche

1. Halbleitervorrichtung vom Quanteninterferenztyp mit einem Kanalmittel (4, 6; 55) um Träger hindurchzulassen, von einem ersten Bereich (31; 36; 52) der Vorrichtung, in welchen Träger injiziert werden, zu einem zweiten Bereich (32; 56) der Vorrichtung, von welchem Träger abgezogen werden, wobei wenigstens ein Teil der genannten Kanalmittel (4, 6; 55) zwei leitende Wege (4, 6; 551a, 551b) umfaßt, die sich parallel zwischen dem ersten und dem zweiten Bereich (31; 36; 52/32; 56) erstrecken, und es eine Feldsteuereinrichtung (35; 59) gibt, die angeordnet ist, um die genannten leitenden Wege einem selektiv variablen elektrischen oder magnetischen Feld zu unterwerfen, um so die Passage der Träger durch die genannten Kanalmittel (4, 6; 55) mittels des Aharonov-Bohm-Effektes zu steuern; gekennzeichnet durch eine Resonanz-Tunnel-Barriere (40; 53), die angeordnet ist, um die Energiepegel der Träger, welche auf die genannten leitenden Wege (4, 6; 551a, 551b) gelangen, auf vorbestimmte schmale Bänder von Energiepegeln zu beschränken.

2. Halbleitervorrichtung nach Anspruch 1, bei der die genannte Resonanz-Tunnel-Barriere zwischen dem genannten ersten Bereich (31; 52) und einem Ende des genannten Kanalmittels (4, 6; 55) angeordnet ist und eine erste Barrierenschicht (41; 531), eine Quantengrabenschicht (43; 532) und eine zweite Barrierenschicht (42; 533) umfaßt.

3. Halbleitervorrichtung nach Anspruch 1, bei der die genannte Resonanz-Tunnel-Barriere zwei Reihen von Resonanz-Tunnel-Elektroden (44, 45) umfaßt, zum Anwenden einer partiellen Spannung auf die genannten Kanalmittel (4, 6), welche Elektroden (44, 45) längsseits der genannten Kanalmittel (4, 6) an einem Ende der genannten leitenden Wege (4, 6) angeordnet sind, welches dem genannten ersten Bereich (36) der Vorrichtung benachbart ist.

4. Halbleiterspeichervorrichtung nach Anspruch 2 oder 3, bei der die genannten Kanalmittel (4, 6) als parallele Potentialgräben in einer Halbleiter-Heterostruktur mit einer Banddiskontinuität auf einem monokristallinen Substrat (1) ausgebildet sind, die genannte Resonanz-Tunnel-Barriere (40) und der genannte erste Bereich (31; 36) in der Reihenfolge an einer Sourceseite der genannten Heterostruktur angeordnet sind, und der genannte zweite Bereich (32) an der Drain-Seite der genannten Heterostruktur angeordnet ist.

5. Halbleiterspeichervorrichtung nach Anspruch 2 oder 3, bei der der genannte erste Bereich, die genannte Resonanz-Tunnel-Barriere (53), das genannte Kanalmittel (55) und der genannte zweite Bereich (56) in der genannten Reihenfolge auf einem Halbleitersubstrat (51) laminiert sind.

6. Halbleitervorrichtung nach Anspruch 4 oder 5, bei der das genannte Feldsteuermittel (35; 59) eine Gateelektrode umfaßt, die auf einem der genannten Kanalmittel (4, 6; 55) angeordnet ist, und eine gemeinsame Elektrode, die auf der gegenüberliegenden Seite der genannten Kanalmittel (4, 6; 55) angeordnet ist, um der genannten Gateelektrode (35; 59) zugewandt zu sein.

7. Halbleitervorrichtung nach Anspruch 6, bei der eine zusätzliche Gateelektrode (35) auf einer Seite des genannten Kanalmittels (4, 6) vorgesehen ist, welche Gateelektroden (35) unabhängig voneinander EIN/AUS-steuerbar sind.

8. Halbleitervorrichtung nach Anspruch 7, bei der zusätzliche Kanalmittel (4, 6) in der genannten Halbleiter-Heterostruktur gebildet sind.

## Revendications

1. Dispositif à semiconducteur du type à interférences quantiques, possédant des moyens formant un canal (4, 6 ; 55) servant à laisser passer des porteurs d'une première région (31 ; 36 ; 52) du dispositif, dans laquelle des porteurs sont injectés, à une deuxième région (32 ; 56) du dispositif, de laquelle des porteurs sont évacués, au moins une partie desdits moyens qui forment un canal (4, 6 ; 55) comprenant deux trajets conducteurs (4, 6 ; 551a, 551b) qui s'étendent parallèlement entre lesdites première et deuxième régions (31 ; 36 ; 52/32 ; 56), des moyens de commande de champ (35 ; 59) étant prévus pour soumettre lesdits trajets conducteurs à un champ électrique ou magnétique sélectivement variable de façon à commander le passage de porteurs dans lesdits moyens formant un canal (4, 6 ; 55) grâce à l'effet Aharonov-Bohm; caractérisé par une barrière à effet tunnel résonnant (40 ; 53) destinée à limiter les niveaux d'énergie des porteurs entrant dans lesdits trajets conducteurs (4, 6 ; 551a, 551b) à une étroite bande prédéterminée de niveaux d'énergie.

2. Dispositif à semiconducteur selon la revendication 1, où ladite barrière à effet tunnel résonnant est disposée entre ladite première région (31 ; 52) et une extrémité desdits moyens formant un canal (4, 6 ; 55) et comprend une première couche de barrière (41 ; 531), une couche de puits quantique (43 ; 532), et une deuxième couche de barrière (42 ; 533).

3. Dispositif à semiconducteur selon la revendication 1, où ladite barrière à effet tunnel résonnant comprend deux lignes d'électrodes à effet tunnel résonnant (44, 45) servant à appliquer une tension partielle auxdits moyens formant un canal (4, 6), lesquelles électrodes (44, 45) sont disposées le long desdits moyens formant un canal (4, 6) à celle des extrémités desdits trajets conducteurs (4, 6) qui est adjacente à ladite première région (36) du dispositif.

4. Dispositif à semiconducteur selon la revendication 2 ou 3, où lesdits moyens formant un canal (4, 6) se présentent sous la forme de puits de potentiel parallèles dans une hétérostructure semiconductrice ayant une discontinuité de bande sur un substrat monocristallin (1), ladite barrière à effet tunnel résonnant (40) et ladite première région (31 ; 36) étant disposées dans cet ordre du côté source de ladite hétérostructure, et ladite deuxième région (32) étant disposée du côté drain de ladite hétérostructure.

5. Dispositif à semiconducteur selon la revendication 2 ou 3, où ladite première région (52), ladite barrière à effet tunnel résonnant (53), lesdits moyens formant un canal (55), et ladite deuxième région (56) sont placés de manière stratifiée dans cet ordre sur un substrat semiconducteur (51).

6. Dispositif à semiconducteur selon la revendication 4 ou 5, où lesdits moyens de commande de champ (35 ; 59) comprennent une électrode de grille disposée sur un côté desdits moyens formant un canal (4, 6 ; 55) et une électrode commune disposée sur le côté opposé desdits moyens formant un canal (4, 6, 55) de façon à être en regard de ladite électrode de grille (35 ; 59).

7. Dispositif à semiconducteur selon la revendication 6, où une électrode de grille supplémentaire (35) est prévue sur un côté desdits moyens formant un canal (4, 6), les électrodes de grille (35) pouvant être commandées en position de conduction ou de blocage indépendamment les unes des autres.

8. Dispositif à semiconducteur selon la revendication 7, où des moyens du type canal supplémentaires (4, 6) sont formés dans ladite hétérostructure semi-conductrice.
